# EUROPEAN PATENT APPLICATION

(11) **EP 0 725 435 A2**
(43) Date of publication of application: **07.08.1996**
(21) Application number: 96870010.4
(22) Date of filing: 02.02.1996
(51) Int. Cl.: H01L 21/66

(54) **Electrochemical measurements for in-situ monitoring of semiconductor wafer cleaning processes**

(30) Priority: 03.02.1995 US 384279
(71) Applicant: INTERUNIVERSITAIR MICRO-ELEKTRONICA CENTRUM VZW, B-3001 Heverlee (BE)
(72) Inventor: Schmidt, Harald Okorn, 3000 Leuven (BE); Teerlinck, Ivo Geert Maurits, 3001 Heverlee (BE); Heyns, Marc Marcel Annie Maria, 3210 Linden (BE)
(74) Representative: Van Malderen, Joelle

(57) **Abstract**

The method for monitoring the physical or chemical action of a chemical solution on a surface of a semiconductor material in contact with said chemical solution comprising:
a. measuring the potential difference between a working electrode and a reference electrode, said reference electrode being in contact with said chemical solution, thereby obtaining measurement data,
b. obtaining condition data which indicate the physical and/or chemical condition of said semiconductor material over a predetermined period of time; and
c. correlating said condition data to said measurement data in order to monitor the physical or chemical action of said chemical solution on said surface.

## Description

### Field of the Invention

The present invention relates to a method for monitoring of the electrochemical, chemical and physical properties of semiconductor surfaces in chemical solutions. In particular, the present invention relates to a method for monitoring of the oxidizing, etching, dissolving or cleaning action of a chemical solution via open circuit potential measurements on a semiconductor wafer which is immersed in the chemical solution.

### Background of the invention

The preparation of a semiconductor surface prior to various processing steps such as oxidation, deposition or growth processes has become one of the most critical issues in semiconductor technology. With the rapid approach of sub-halfmicron design rules, very small particles and low levels of material impurities (of the order of 10¹⁰ atoms/cm²) can have a drastic effect on process yields. A commonly used technique to reduce foreign particulate matter and other contaminants on semiconductor surfaces is the immersion of wafers in chemical solutions.

The evaluation of the quality of process chemicals in these solutions has become a major issue. It has been discovered that the impurity contamination level on semiconductor surfaces is critically dependent on the types of chemicals used to clean these surfaces, on the order in which the process sequence is effectuated, and on the stability or exhaustion of the mixtures or added complexants used (M. Heyns et al., Materials Research Society Spring Meeting, San Francisco, 1993; H. Schmidt et al., co-pending U.S. patent application entitled "Method for Evaluating, Monitoring or Controlling the Efficiency, Stability, or Exhaustion of a Complexing or Chelating Agent Present in a Chemical Solution Used for Oxidizing, Dissolving, Etching or Stripping a Semiconductor Wafer", filed February 3, 1995).

Chemical mixtures used in cleaning or etching silicon wafers include H₂SO₄/H₂O₂-solutions, NH₄OH/H₂O₂/H₂O, HCl/H₂O₂/H₂O, HF/H₂O₂/H₂O, H₂SO₄/O₃, phosphoric acid, H₂O-HF-HCl, BHF, HF/H₂O₂, HF/NH₄F/H₂O, HNO₃, (CH₃)₃N⁺-CH₂CH₂OHOH, (CH₃)₃N⁺-CH₂CH₂OHOH/H₂O₂/H₂O, (NH₄)₂SO₄/H₂SO₄, H₂S₂O₈/H₂SO₄, O₃/H₂O, H₂SO₄/O₃/H₂O, HF/HNO₃ and HF/H₂O. Other alternatives have been proposed in European patent applications numbers EP-477504 and EP-560324. A typical cleaning process for semiconductor wafers is disclosed in a paper by W. Kern in RCA Review 31, 187 (1970). Other processes are described in the reference Handbook of Semiconductor Wafer Cleaning Technology, W. Kern, Noyes (1993).

State-of-the-art analysis tools can measure the concentration of chemicals in the mixture by optical means, e.g. by infrared absorption or ultraviolet excitation measurements (cf. Kurabo, technical sheets, or Kokai 54-33673, Patent Abstracts of Japan, Section E 109, Page 140). These techniques, however, can only provide information on the composition of a mixture, and do not provide any information on the activity of the mixture and on the progress of the chemical or physical processes occurring at the semiconductor surface.

It has been established that the etching process of semiconductor surfaces shows electrochemical features (D.R. Turner, J. Electrochem. Soc. 107, 810 (1960)), and that there are anode and cathode sites on the surface of a semiconductor with local currents flowing between them.

This feature was advantageously exploited in European patent application EP-A-0390254, which discloses a method for stabilizing alkaline cleaning baths for Si wafers containing hydrogen peroxide (H₂O₂). This method devolves on measuring the potential of an Si wafer in the bath with respect to a reference electrode and an increasing of the H₂O₂ concentration in the bath again if the potential is markedly displaced to more negative values. This method ensures a simple manner that the H₂O₂ concentration of the bath decreases to values at which the Si wafers are incipiently etched.

However, this document fails to disclose the use of open circuit potential measurements for monitoring the oxidizing, etching, dissolving or cleaning action of a chemical solution on a semiconductor wafer immersed in that solution and for probing the surface condition of the semiconductor wafer. Furthermore, this document fails to disclose a reliable method for monitoring in-situ the kinetic and the progress of chemical or physical processes occurring at semiconductor surfaces. Finally, this document fails to disclose a method which is able to predict quantitatively the behavior or the quality of the chemical mixtures used for semiconductor processing.

### Aims of the Present Invention

The first aim of the present invention is to propose the development of appropriate monitoring method and device which could be capable of providing information and more particularly real-time information on the kinetic and the progress of chemical or physical processes occurring at semiconductor surface.

Particularly, the present invention aims to give a method for monitoring the oxidizing, etching, dissolving or cleaning action of a chemical solution on a semiconductor wafer immersed in that solution and for probing the surface condition of the semiconductor wafer.

The present invention also aims to give a method which will be able to predict quantitatively the behavior or the quality of chemical mixtures used for semiconductor processing and which are sufficiently viable.

### Main Characteristics of the Invention

The present invention relates to a method for monitoring the physical or chemical action of a chemical solution that is in contact with a semiconductor material. This method includes first measuring the potential difference between a working electrode and a reference electrode. The reference electrode is in contact with the chemical solution. Next, the method involves obtaining condition data which indicate the physical and/or chemical condition of the semiconductor material. Finally, this method involves correlating the condition data and the measurement data.

The reference electrode can be any kind of reference element which does not or slowly get attacked or degraded by the solution in which the element is immersed. The reference element can be mounted into the chemical bath or placed in contact with it via a salt bridge. Several examples of reference electrodes are described hereunder.

By slowly it is meant that the reference electrode is substantially slower attacked by the solution than the working electrode.

The working electrode can be any material which accurately simulates or is subjected to the action, such as the oxidizing, etching, cleaning or dissolving action, of a chemical solution on a semiconductor wafer (the term "semiconductor material" generally encompasses these materials). A conductive polymer can be possibly used as well.

The working electrode can be chosen as one wafer of a processed batch of silicon wafers. Alternatively, the working electrode can be a small piece of such a wafer which is sufficiently large to provide a surface in contact with the chemicals or chemical bath. The working electrode is mounted either in a wafer carrier or in a separate shed which provides means for electrical connections to the outside of the bath. The working electrode can as well be a semiconductor wafer which is immersed continuously or at specified time intervals in a chemical bath so as to monitor the bath's oxidising, etching, dissolving or cleaning power or the exhaustion of the chemicals in the bath.

The semiconductor working electrode is preferably sealed in a stable material such as PFA (polyfluoroalkoxy copolymer) so as to avoid any interaction between the wafer's backside and the chemical mixture, i.e. so that only a desired surface or surfaces are in contact with the chemical solution.

It is another characteristic of the present invention that the open circuit potential differences are measured in such a way that these data can be correlated to the progress of the physical or chemical reaction occurring at the wafer's surface and that in this way the semiconductor surface condition is probed. This characteristic of the invention allows for the use of the open circuit potential data for a qualitative and quantitative analysis aimed at providing information on the semiconductor wafer's surface condition.

Details on standard electrochemical measurements are described, for example, in "Principles of Electrochemistry" by J. Koryta, published by Wiley (1993).

Examples of cleaning or etching solutions are H₂SO₄/H₂O₂/H₂O, NH₄OH/H₂O/H₂O, HCl/H₂O₂/H₂O, HF/H₂O₂/H₂O, H₂SO₄/O₃, phosphoric acid, H₂O-HF-HCl, BHF and HF/H₂O₂, HF/NH₄F/H₂O, HNO₃, (CH₃)₃N⁺-CH₂CH₂OHOH, (CH₃)₃N⁺-CH₂CH₂OHOH/H₂O₂/H₂O, (NH₄)₂SO₄/H₂SO₄, H₂S₂O₈/H₂SO₄, O₃/H₂O, H₂SO₄/O₃/H₂O, HF/HNO₃ and HF/H₂O.

According to one embodiment, the measurement data are obtained by measuring a transient rise in potential difference between said working electrode and reference electrode. This transient rise occurs immediately after immersion of said semiconductor material in said chemical solution and foregoing a steady state behavior of said measurement data.

According to another preferred embodiment, the measurement data are obtained by measuring a steady state behavior in the potential difference between said working electrode and said reference electrode. This steady state occurs after the transient rise in the potential difference described hereabove.

Reference or condition data are acquired with settled techniques for analysing semiconductor surfaces, such as state-of-the-art contact angle measurements and infrared spectroscopy.

In another embodiment, the step which involves obtaining condition data includes obtaining data which indicate the physical and/or chemical condition of a surface of the semiconductor material exposed to the chemical solution.

In one embodiment of this present invention, a predetermined endpoint of the physical or chemical action on the semiconductor is detected.

The invented method can additionally comprise steps for determining a unit of condition data which indicate that the semiconductor material should be removed from the chemical solution, determining a piece of measurement data which correspond to the piece of condition data, and using the piece of measurement data as an indication that the semiconductor material should be removed from the chemical solution which will also define an endpoint.

In yet another embodiment of the invented method, additional steps that can be carried out which include: determining a unit of condition data which indicate that the semiconductor material should be removed from the chemical solution; determining a unit of measurement data which correspond to the unit of condition data; and using the unit of measurement data as an indication that the chemical solution should be refreshed which will define an endpoint.

These measurements provide real-time information on the progress of cleaning or etching reactions on the surface of a semiconductor, including informations on the reaction rate, the reaction saturation and the optimum working conditions (e.g., temperature, mixing ratio, or agitation such as by stirring or sonic waves) of chemical mixtures. The measured data can be quantitatively evaluated to yield insights into the underlying physico-chemical mechanisms of these reactions.

The measurements taken according to the present methods can further provide real-time informations on when a predetermined endpoint of a reaction on a semiconductor surface is reached. This avoids unnecessarily prolonged processing times. In addition, these measurements can provide informations on the dissolving, oxidizing, etching or cleaning power of a given chemical mixture. This helps to determine when a chemical mixture is used up and therefore provides a precise control on the time period required for refilling baths with new chemicals.

It is a further characteristic of the present invention that the open circuit potential data which are gathered according to the present invention can be used to optimize cleaning or etching solutions. This data can be used to control wafer etching or cleaning processes as well as to indicate the predetermined endpoints of a reaction occurring on the surface of a semiconductor wafer.

In using OCP data to optimize cleaning or etching solutions, the following procedure can be followed. The oxidizing, cleaning, etching or dissolving action of a semiconductor wafer is monitored via OCP measurements. The OCP data are calibrated using state-of-the-art analysis tools. Thus, an OCP measurement or response corresponding to a given chemical or physical reaction can be determined. The responses of different solutions (e.g., solutions having concentration differences) under different working conditions (such as temperature or the amount of agitation of the solution) can thus be compared. Accordingly, OCP analysis can be used to optimize cleaning or etching solutions.

In using OCP data to control wafer cleaning or etching processes, the following procedure can be followed. After calibrating the OCP curves for a given solution/semiconductor system, an upper and lower acceptability limit can be determined. This upper and lower acceptability limit can consist of a set of two OCP curves boarding a process window in terms of OCP traces versus time. Once the OCP curves for a given process in a semiconductor wafer fabrication being monitored pass beyond these borders, the process can be interrupted. Alternatively, when the OCP curves pass beyond the borders of the predetermined acceptability limit, this can be used as a signal that the chemical bath needs to be refreshed (i.e., one or more chemicals need to be added) or exchanged.

In order to use OCP data in endpoint detection, the following procedure can be followed. Once the oxidizing, cleaning, etching or dissolving action of a chemical solution on a semiconductor wafer is calibrated in terms of OCP data, depending on the desired outcome of the process, an endpoint can be defined in terms of OCP data. In a subsequent experiment using an identical solution/semiconductor system, once the predetermined endpoint is reached, the process is interrupted or taken as an indication that the solution needs to be changed or refreshed.

It is another characteristic of the present invention that the open circuit potential data which are obtained and used according to the invention can be obtained on-line, off-line, in-situ, ex-situ, and/or in sampling mode. By in-situ, it should be understood that the measurements are performed in the chemical solution or just above said chemical solution.

A further aspect of the present invention comprises an apparatus for monitoring in-situ the oxidising, cleaning, etching or dissolving action of a chemical solution on a semiconductor material immersed in the chemical solution. The inventive apparatus comprises a reference electrode and a semiconductor working electrode connected by electrical means to the reference electrode.

The working electrode is made from a semiconductor material, preferably silicon. In one embodiment, the apparatus additionally comprises a means for displaying data indicating the potential difference between the working electrode, such as an X-Y plotter. The silicon working electrode can also be sealed in an isolating ring, which can be made for example from either PFA or PTFE or PP or PE. The silicon working electrode can further be mounted in a shed of a wafer carrier. In addition, the apparatus can include a salt bridge for connecting the reference electrode to a chemical solution.

The reference electrode is any element which does not or slowly get attacked or degraded by the solution in which the element is immersed. For instance, the reference electrode can be standard Ag/AgCl electrode or a saturated colomel electrode or a normal Hydrogen electrode even an Si wafer and more particularly a Hydrogen-passivated or Oxygen-passivated Si wafer preferably encapsulated in PFA.

### Brief Description of the Drawings

- **Figure 1**: is a schematic representation of a measurement set up in accordance with the invention.
- **Figure 2**: is a schematic view of a measurement device using one wafer from a batch of wafers and a reference electrode to perform measurements.
- **Figure 3**: is a schematic view of a measurement device using a reference electrode separated from the treatment bath by a salt bridge and a monitor sample.
- **Figure 4**: shows a preferred embodiment of the silicon working electrode mounted in a carrier.
- **Figure 5**: shows the OCP response of a p-type Si wafer when immersed in a oxidized state into a 0.1% HF solution and wherein the measurement was performed two times with different reference electrodes with the same sample free treatment and measurement procedure.
- **Figure 6**: shows the shift of the OCP curve to longer etch times and lower PMP with the thickness of wet chemical oxides in an HF solution.
- **Figure 7**: represents the typical time evolution and the reproducibility of the OCP of a p-type Si wafer when immersed into a 0.25% HF solution under clean room light conditions.
- **Figure 8**: is a schematic and simplified two dimensional representation of the major changes on the silicon <100> surface when immersed in an oxidized state into an HF solution.
- **Figure 9**: represents the correlation between the time evolution of the OCP and the contact angle of a p-type Si wafer in a 0.5% HF solution (clean room light conditions, pre-conditioning: SPM, 10 minutes at 95°C, followed by 10 minutes DI water rinse).
- **Figure 10**: represents the OCP curve of a p-type Si wafer when immersed into a 0.1% HF solution under clean room light conditions (measured vs. a hydrogen passivated Si-wafer of the same type as reference electrode) with circles marking at the times where the samples for MIR-FTIR measurements (displayed in Figure 11) were taken out from the HF bath (pre-conditioning: SPM, 10 minutes at 101°C, followed by 10 minutes DI-water rinse).
- **Figure 11**: represents the p-polarised SiHₓ spectra as a function of the etching time in a 0.1% HF solution.
- **Figure 12**: represents the OCP (from figure 10) versus integrated absorbance of the MIR-FTIR spectra. The integrations were performed in the range from 2030 to 2170 cm⁻¹, displayed in figure 11.
- **Figure 13**: represents the correlation between the time evolution of the OCP (from figure 10) and the corresponding normalized integrated absorbance calculated from the curves in figure 11.
- **Figure 14**: represents typical time evolution and reproducibility of the OCP of a p-type Si wafer when immersed into an SPM mixture at 95°C.
- **Figure 15**: is a schematic and simplified representation of the major changes on a silicon <100> surface when immersed after hydrogen passivation into an SPM mixture
- **Figure 16**: represents the time evolution of the OCP of a p-type Si wafer as function of the age and temperature of an SPM mixture.
- **Figure 17**: represents pseudo-dielectric functions, real (Δεᵣ) and imaginary (Δεᵢ)parts plotted versus photon energy for p-type Si wafer treated in different mixtures.
- **Figure 18**: represents XPS spectra for p-type Si samples treated in different SPM mixtures.

### Detailed Description of Several Embodiments

Reference is now made to the figures, wherein like parts are designated with like numerals throughout.

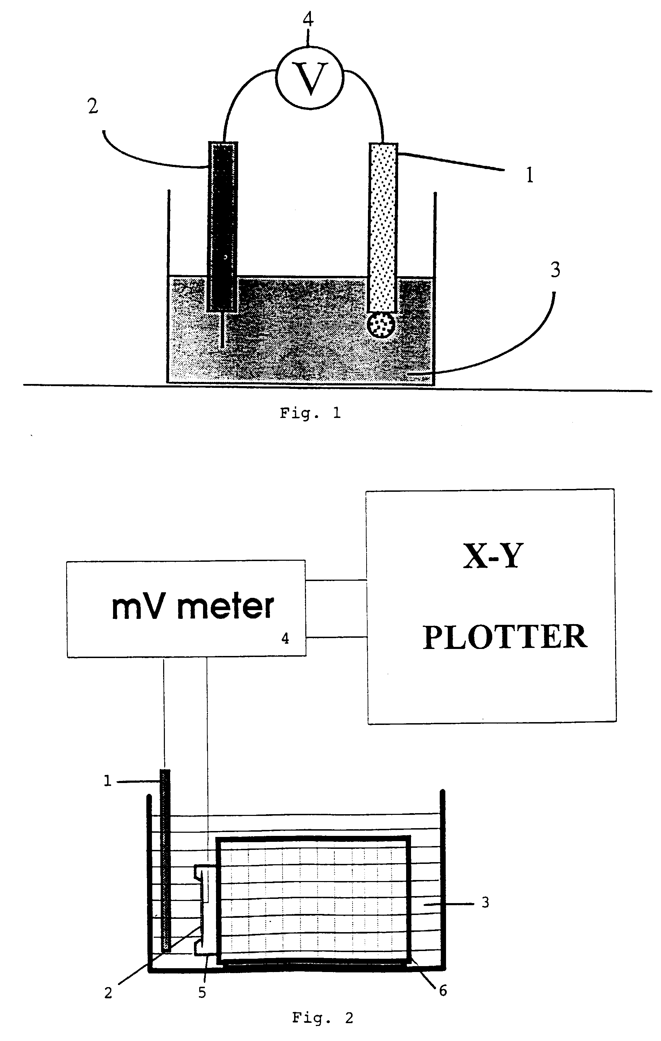

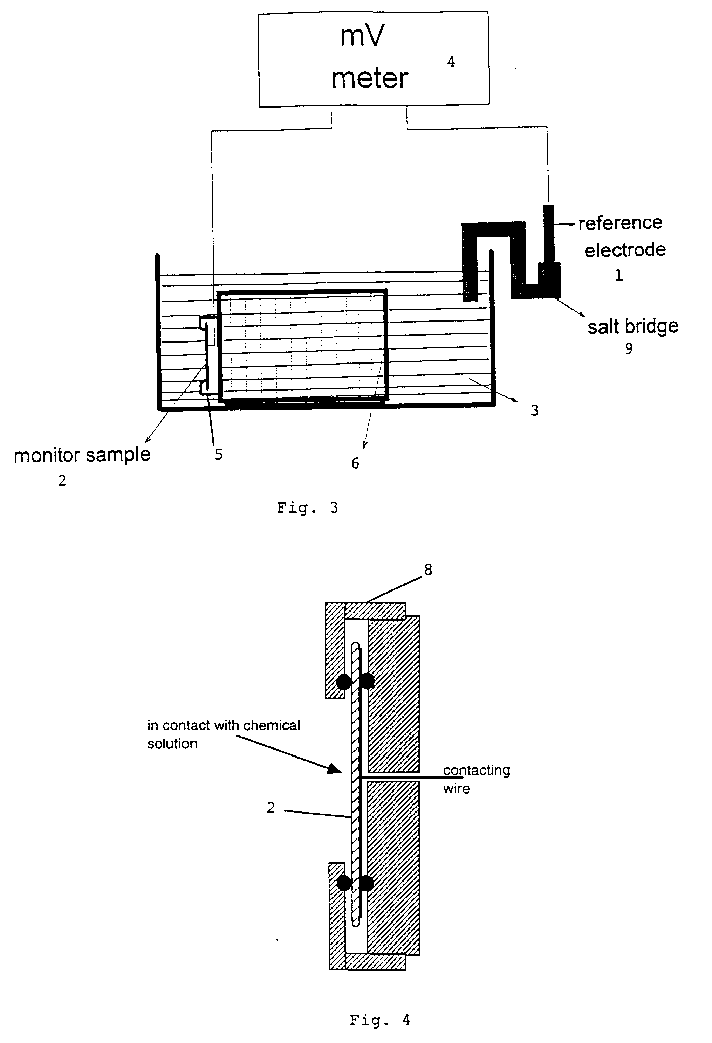

Figure 1 shows a possible measurement setup consisting of a reference electrode (1) e.g. Ag/AgCl, and a semiconductor working electrode (2), both immersed in a chemical bath (3) The potential variation between both electrodes can be monitored using a mV-meter (4) with a very high inner resistivity in order to provide currentless measurements. This meter can be installed on each cleaning or etching tank used in a semiconductor processing line. The reference electrode (1) can be any kind of reference element which does not get or slowly get attacked by the solution in which it is immersed.

By slowly, it should be understood that the reference electrode (1) is substantially slower attacked or degraded by the solution than the working electrode (2).

Figure 2 discloses another realization of the present invention hereby characterized in that one wafer out of a processed batch including several silicon wafers is used as a reference silicon working electrode (2) for the whole batch. This wafer is mounted in a separate shed (5) of a wafer carrier (6) in which means for an electrical connection to the outside of the bath (not shown) is provided. In one embodiment, the measurement shed and carrier are designed to be easily separable.

Figure 3 illustrates an embodiment of the present invention which is similar to that shown in Figure 2. However, in Figure 3, the reference electrode (1) is not mounted into the cleaning or etching bath but is instead in contact with the bath via a salt bridge (9).

The working electrode could be the whole wafer or only a small piece of any semiconductor and/or a metal. In this preferred embodiment, whole silicon device wafers, 125 or 150 mm in diameter, have been mounted in a specially designed single wafer holder made of PFA (per-fluor alkoxy copolymer). Only the polished front side of the wafer is exposed to the chemical solution under investigation. A very important issue is that a very good ohmic contact between the backside of the wafer and the wiring, connecting the electrode to the mV-meter is established. For p-type wafers this can be achieved by sputtering 700 nm Al on the backside with a consecutive sinter process at 435°C for 30 min. For n-type samples a double layer of 50 nm Ti followed by 700 nm Al is sputtered on the backside, also followed by the above heat treatment.

Figure 4 shows an attachment of a silicon working electrode mounted in a carrier. This electrode consists of a silicon wafer (2) sealed in an isolating ring (8) which can be made, e.g., out of PTFE (polytetrafluoroethylene, sold as Teflon®) or PFA, so as to avoid any interaction between the silicon backside and the chemical mixture. The ring (8), of course, does not need to be round in shape. A backside ohmic contact (10) to the silicon wafer (2), including a contacting wire (11), is provided, e.g. by sputtering and sintering of aluminium. The contact (10) is connected with a Voltmeter (not shown) having a very high inner resistivity via the contacting wire (11).

Concerning the reference electrode it should be noted that the high temperature of certain mixtures (around 100°C) and their incompatibility with electrodes made from glass (hydrofluoric acid), makes it sometimes difficult to find a suitable reference system. Within the development of this technique several different embodiments have been tested and are described in the following:

For absolute measurements, a standard Ag/AgCl (3M KCl/sat. AgCl, +204mV vs. N.H.E. at 20°C) electrode, fitted with a PFA capillary salt bridge has been used very successfully in HF, SCl and aqueous NH3 solutions. The leaking rate of this capillary was determined to be less then 200 µl saturated KCl electrolyte per 24 hours.

Another reference device tested is also based on a Ag/AgCl standard reference electrode, containing 2 compartments covered in epoxy material. The upper compartment contains the Ag/AgCl reference system, the lower part the salt bridge (1 M KCl) with a porous platinum junction to the solution. A glass fiber forms the junction in-between the upper and the lower part. This reference electrode has a good stability but has also the disadvantage of a relative high leaking rate of the salt bridge solution. Also an additional potential drop at the glass fiber junction results in a different potential vs. the N.H.E. than expected for a Ag/AgCl reference electrode.

Some measurements (in SPM) have also been performed with normal Ag/AgCl electrodes made from glass where the filling solution (3M KCl/sat. AgCl) was exchanged after each measurement. This is necessary in order to avoid an influence on the reference potential by leaking in of sulfur compounds into the Ag/AgCl system.

A preferred reference electrode has been developed in order to allow contamination free measurements (no leaking of salt bridge solutions into the bath). In this case a second, in PFA encapsulated Si wafer has been used as a reference electrode. This reference wafer is of the same type as the working electrode with the only difference, that it is already in a passivated state, i.e. all major surface reactions (oxidation, etching) are completed which results in a relative stable potential. This is achieved by immersion of the reference wafer at least 20-30 minutes before the actual measurement into the solution. Then the working electrode is immersed and the potential changes due to the ongoing surface reactions (on the working electrode) are measured vs. the relative stable potential of the reference wafer.

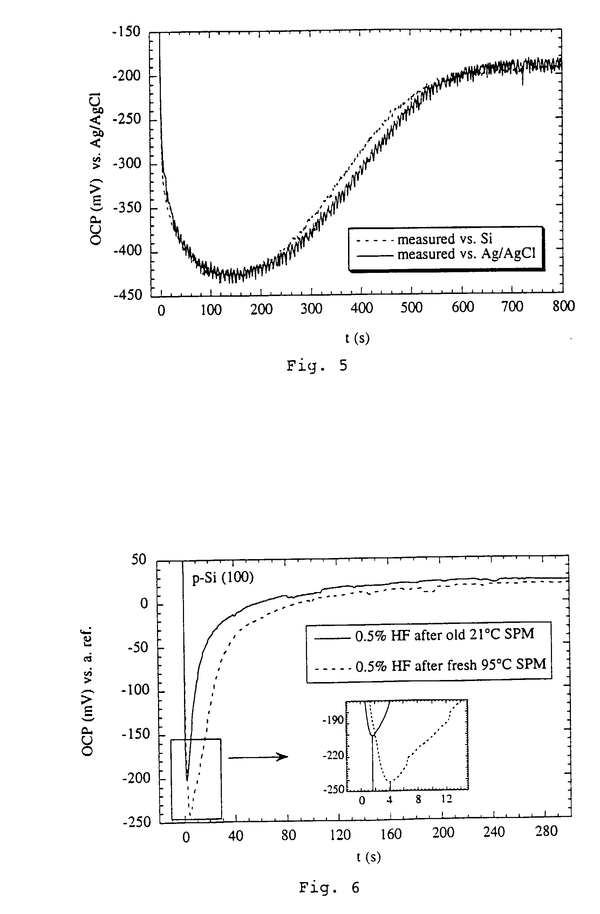

The applicability of this embodiment can be seen from Fig. 5, where the same measurement was performed two times, one time measured vs. a Ag/AgCl standard reference electrode the second time vs. a H-passivated Si wafer (potentials are recalculated vs. Ag/AgCl). In this case the reference wafer has been immersed into the HF solution for around 45 min prior to the displayed measurement in order to achieve a stable hydrogen passivation. The potential of this reference wafer in the HF solution has been measured vs. an Ag/AgCl electrode before and after the measurement displayed and was found to have changed by less then 2 mV.

All experiments were carried out under normal wet-bench light conditions, if not stated otherwise by using high purity chemicals with typical contamination levels of <0.5 ppb or better.

### Examples

Examples of Open Circuit Potential (OCP) measurements are described hereunder for a HF solution (example 1) and for SPM solution (example 2) wherein:

### Measurement Data: OCP Measurements

Silicon device-wafers CZ, 125 and 150 mm, p/B and n/Ph, 16-24 Ωcm and 8.4-15.6 Ωcm respectively, with (100) surface orientation have been applied as working electrodes.

A good ohmic contact between the silicon electrode and the wiring was established by sputtering 700 nm Al (for p-type) and 50 nm Ti/500 nm Al (for n-type) on the backside of the wafer, followed by a sintering process at 435°C for 30 min.

### Condition Data: MIR-FTIR measurements

Double side polished IR-samples (p-type, (100), 10-25 Ωcm) were immersed one after each other into a 0.5% HF mixture after a SPM/DI-rinse pre-treatment. At pre-selected times, determined from the OCP curve, which was measured just before, the samples were taken out from the HF bath and immersed for max. 5 seconds into DI-water and then blow-dried with N2. The samples were then transferred to a Mattson-galaxy FTIR and measured within 20 minutes after preparation with p-polarized light and a resolution of 4 cm⁻¹. All samples are measured with the initial SPM oxide as reference.

### Spectroscopic Ellipsometry: (SE) measurements

Si wafers of the same type as used for the OCP measurements (see above), were immersed together with the working electrode into different SPM or SC1 test solutions after an HF/DI-rinse pre-treatment. After the SPM or SC1, the wafers were rinsed for 10 minutes in DI-water and then blow-dried with N2. Spectroscopic Ellipsometry measurements were performed immediately after sample preparation, using a SOPRA ES4G (photon energy range 2.76 - 4.86 eV in 21 equidistant points, angle of incidence: 80í). To obtain a better accuracy of the tanψ, cosΔ data an averaging over 3 measurements per wavelength was performed.

### X-Ray Photoelectron Spectroscopy (XPS)Measurements:

Samples were prepared in the same way as described above for SE and then analyzed, looking at the Si^{2p}, O^{1s} and the C^{1s} lines.

In the following discussion the experimental results are discussed in the order of the simplicity of the chemical reactions occurring on the electrode surface. Therefore the start will be made with the SPM mixture, where just oxidation of the silicon surface is happening followed by measurements in HF, where already two consecutive processes are happening.

### Example 1: OCP Measurements in HF Mixtures

Another way to estimate the relative difference in the thickness of native oxides on semiconductors is to monitor the OCP as a function of time, while dissolving the oxide in an appropriate medium, e.g. HF. Figure 6 presents the results obtained, when the two different oxides under investigation are etched off in 0.5% HF. The PMP is found to be the point which marks the time, where the major part of the oxide is chemically dissolved and another process (electrochemical etching) is starting to determine the potential change. By assuming that the oxide dissolution time is changing linearly with the oxide thickness, a shift of the PMP by a factor of two would be expected from above SE and XPS measurements, which indeed was observed. The sensitivity of this technique to determine relative differences in the oxide thickness, by comparing the time to reach the PMP of various samples can be strongly increased by using lower HF concentrations.

The more negative PMP measured for the thicker oxide can be qualitatively explained with the reverse of the model given for the SPM oxidation. In this case the thickness of the oxide capacitance, dₒₓ, is decreasing and so a reverse to the SPM oxidation potential change is observed. However quantitative modeling as has been shown for the SPM oxidation is more difficult in this case. First the oxide surface charge might change during the etching dissolution reaction and with this a constant Helmholtz potential can not be assumed anymore. Also, as will be shown in the following, the oxide etching is not absolutely uniform and influences on the potential from the second step, which is electrochemical etching of the last monolayer of silicon is observed.

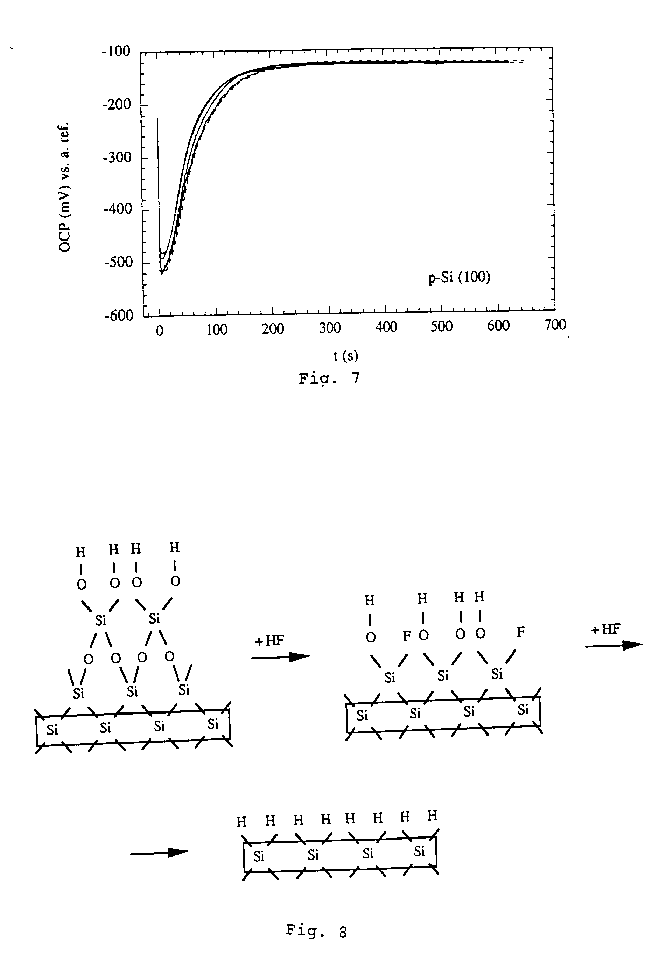

In Fig. 7 the typical time evolution of the OCP of a p-type Si-substrate immersed in a 0.25% HF solution after SC1 oxidation and DI-rinse is presented. The measurement was performed under clean room light conditions. The start OCP value is difficult to quantify because of the finite time needed for immersion of the working electrode (0.5 to 1 second), but was found to have in general a value somewhere around the final steady state potential, in a lot of cases higher. In the initial stage of the reaction, the native oxide layer is dissolved, which results in a drift of the OCP to more negative values. After reaching a characteristic minimum (the PMP), which is defined by several parameters (e.g. thickness of the oxide, etch speed, pH of mixture), the OCP turns into less negative direction until it reaches a quasi steady state potential. Here no major surface changes are happening anymore except a slow chemical corrosion of Si. This results in a slow increase of the potential with time depending on illumination and wafer doping.

Figure 7 displays also the reproducibility of OCP measurements in HF. The same pre-treatment and measurement procedure was performed 6 times on 3 different days with 2 different Si-electrodes of the same type.

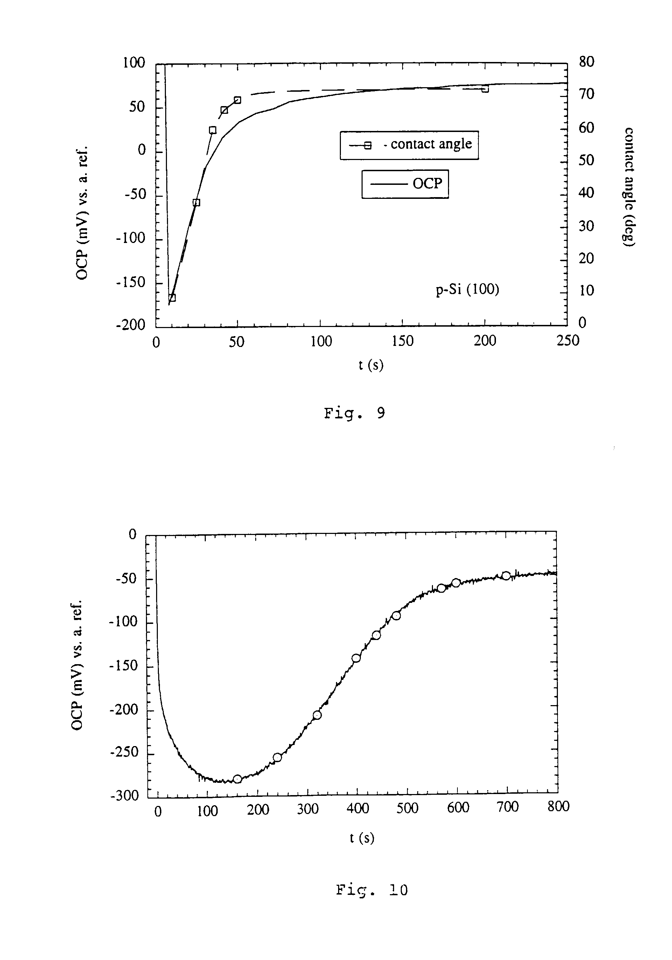

In Figure 8, a very schematic and simplified representation of the major changes on the silicon <100> surface, when immersed in an oxidized state into an HF solution is displayed. In a first step, the wet chemical oxide is dissolved by HF molecules forming SiF₆²⁻ions in solution, which results in a fast drop of the potential to more negative values. The second major step is the etching of the last monolayer of S1²⁺ which is bonded to the bulk material. As a result of this process, the potential is shifting to more positive values. In the end, a relative constant potential is reached indicating that a stable hydrogen passivation of the silicon surface is obtained.

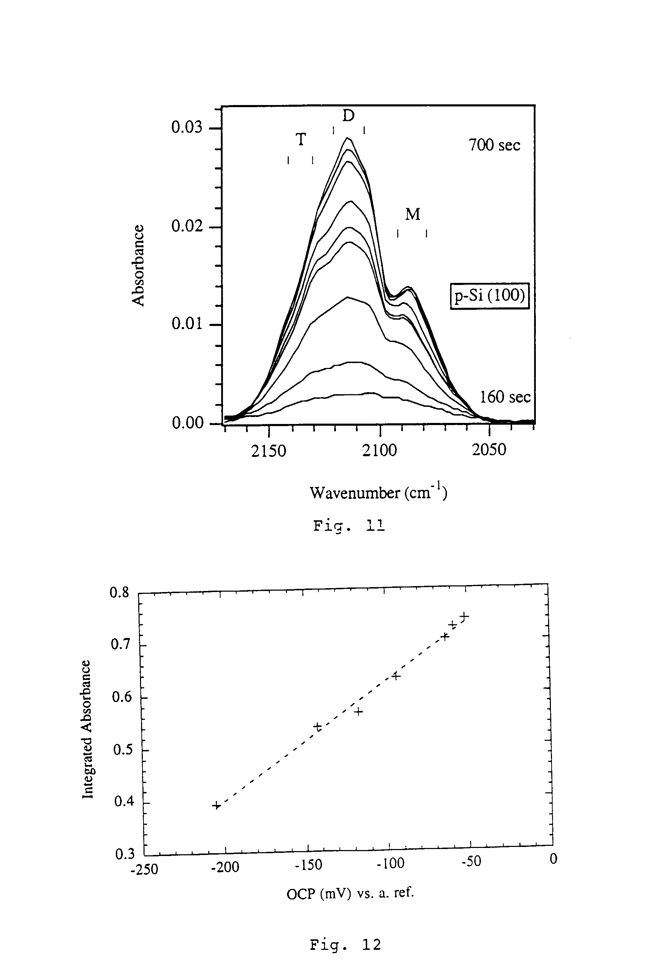

Correlations with contact angle measurements (figure 9) and MIR-FTIR (figures 10 & 11) show that the quasi steady state potential indicates the completion of the hydrogen surface passivation layer.

Figure 9 shows the results of open circuit potential (OCP) measurements in comparison with contact angle (CA) reference measurements on a silicon wafer during and after immersion at specified time periods in a 0.5 % HF solution (0.5 % HF, 99.5% H₂O ). The CA reference technique is a state-of the-art tool for predicting silicon wafer surface conditions (J.L. Alay, Ph.D thesis, KU Leuven (1993). The path of the OCP curve shows a good correlation with the measured contact angle. The detected endpoint (see below) of the reaction (at 180 seconds) coincides for both analysis tools. After 60 seconds, the contact angle measurement indicates an almost complete saturation of the chemical reaction occurring at the silicon surface, although the OCP trace shows still a steady increase.

The difference between both curves is elucidated by the Multiple Internal Reflection (MIR) Fourier Transform Infrared Spectroscopy (FTIR) data shown in figures 10 & 11.. Figure 10 represents unpolarized MIR spectra of the SiHₓ stretching modes as a function of the etching time in a 0.5% HF/H₂O solution. Mono- (M), di- (D) and tri- (T) hybrid peaks can be distinguished. Asymmetric (AS) and symmetric (SS) stretching modes are indicated. From these it can be seen that the H-termination still increases between 60 and 300 seconds. This example shows that the OCP measurements provide a sensitive technique to monitor the build-up of the H-termination of a silicon wafer surface and to determine the endpoint (see below) of the H-termination process. This example further shows that the OCP data obtained in this configuration allows for quantitative extrapolations or predictions of the silicon surface conditions.

In figure 12, the integrated absorbance calculated from the curves in figure 11 is plotted versus the corresponding OCP values. The fit has been performed for values starting from the linear range of the OCP-time relationship until the quasi-steady state range. As a result, a linear correlation was obtained.

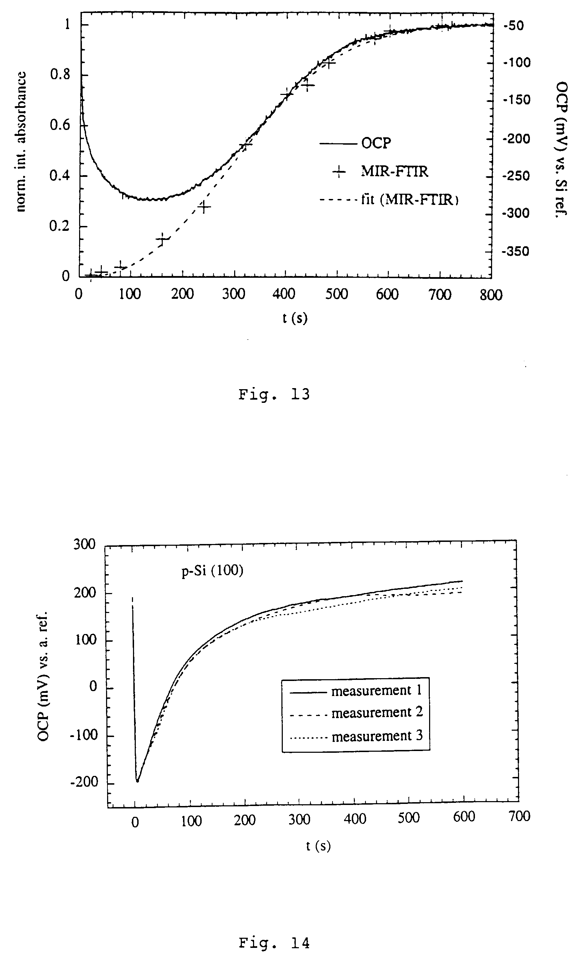

As displayed already in figures 10 & 11, MIR-FTIR measurements have also been performed at shorter etching times before and after the PMP. The results are displayed in figure 13 together with the corresponding OCP curve. In this case, the integrated absorbance has been normalized under the assumption that in the end a 99% coverage of the surface with Si-Hₓ group is reached, which is more or less justified by measurement results obtained by Gräf et al. This graph shows that the etching of the last monolayer of oxidized Si starts already slowly before the PMP and yields around 10% coverage of the surface by Si-Hₓ groups at the PMP. This electrochemical etching of the surface influences the OCP curve and seems to become the only dominating surface reaction after around 350 seconds, where the IR and the OCP curves are matching together.

### Example 2: OCP measurements in SPM mixtures

When Si is being oxidized, the Si/SiO2 interface is being displaced step by step from the original Si surface and located deeper into the Si wafer. For this process the oxidizing species moves through the oxide layer to react with Si at the interface. It is obvious so, that such an oxidation process involves a drastic change of the chemical and physical appearance of the Si surface and therefore a change in the potential distribution at the interface would be expected.

In Figure 14 a typical time response of the OCP of a hydrogen passivated Si surface is presented, when being immersed in a strongly oxidizing chemical mixture. The results from three identical measurements are presented to demonstrate the high reproducibility of the measurement technique.

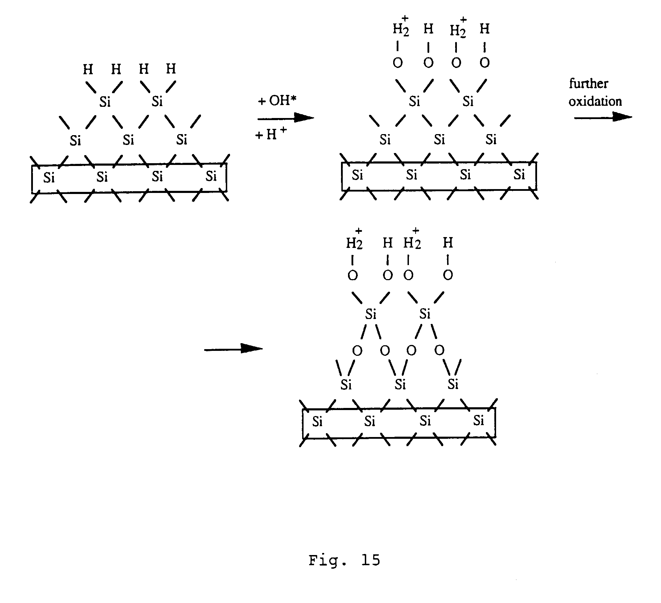

In the beginning a very sharp decrease of the potential to more negative values is observed yielding in a characteristic minimum potential which is in the further discussion called the PMP (Point of Minimum Potential). By comparing with Fig. 15 in this initial phase (lasting around 4 to 5 seconds) the hydrophobic surface turns into a hydrophilic one by exchanging its surface hydrogen atoms with partly protonated hydroxyl groups. This first step is believed to be an oxidative attack on the hydrogen passivated silicon by strong oxidizing species existing in this mixture. A free hydroxyl radical is drawn here as an example which is an intermediate in the reduction of H₂O₂, S₂O₈²⁻ and H₂SO₅.

After this initial trop the OCP turns into less negative direction with a decreasing rate as the oxidation process continues. Further steps involve the backside oxygen insertion to result in a wet chemical oxide of a few monolayers thickness. It should be noted here, that the general appearance of OCP measurement curves is very similar for most of the investigated electrolytes in this work. However significant differences exist and will be discussed as they appear throughout this sequel.

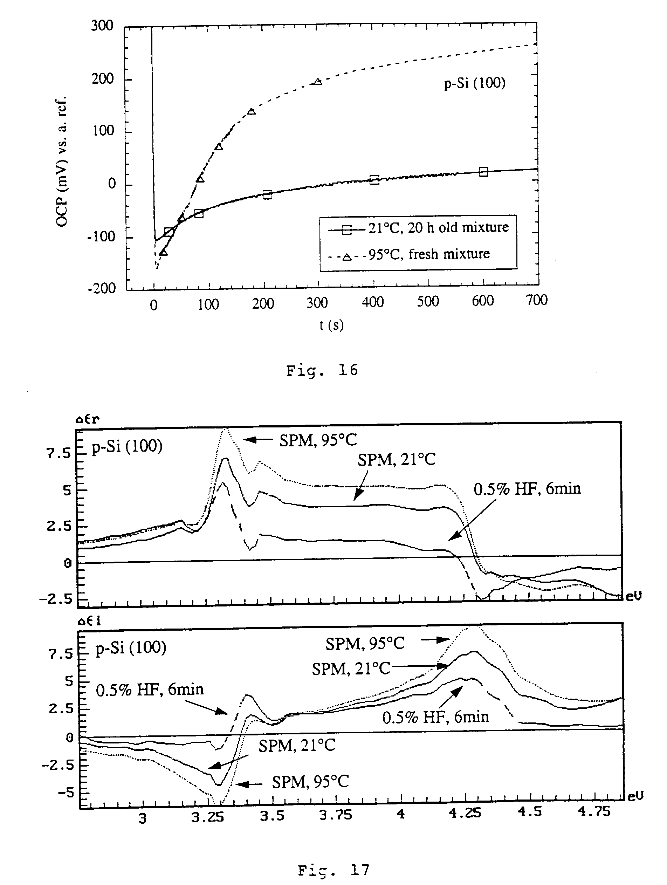

Figure 16 represents results, where the oxidizing power of an SPM mixture was tested as a function of bath age and temperature. Information which can be obtained from these curves is the slope of the potential change after the PMP, and Δ_{OCP}, which is defined as the absolute potential difference between the PMP and the final potential at which a steady state of the oxidation reaction is reached, or the measurement is being stopped (i.e. where the sample is taken out from the solution).

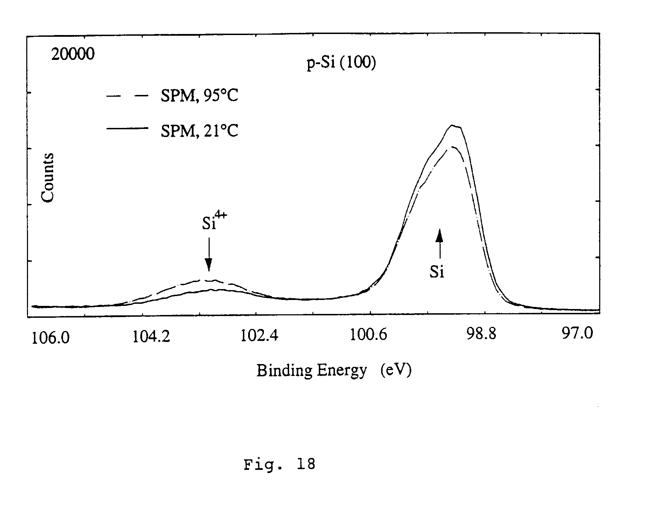

Investigations made with SE on these two oxides are showing a small but clear and significant difference in the oxide thickness (refractive index) between them and also relative to a H-passivated surface, which was measured additionally. Because of lack of an appropriate physical model for the oxide layers, the dielectric functions, real (εᵣ) and imaginary parts (εᵢ), are calculated assuming that no surface layers are present on the Si substrate and then compared with reference data for a bare Si surface to obtain Δεᵣ and Δεᵢ (pseudo-dielectric functions, Fig. 17). By this approach the small difference between the two thin oxide layers is strongly amplified. Additional XPS investigations on these two different oxides confirmed the findings with SE (Fig. 18).

These suggests, that the slope of the potential change after the PMP and the absolute difference between the PMP and the final potential (Δ_{OCP}) can be correlated to the oxidation speed and the resulting oxide thickness respectively. Table 1 lists values for the oxide thickness calculated from SE and XPS data by applying models used for very thin thermal oxides (2 - 3 nm). An additional measurement has been carried out with an SPM mixture at 75°C. The difference in the oxide thickness between SE and XPS is related to the models applied for the calculations. However, no further attempt will be made here to explain these models. For further calculations the values calculated from SE are used.

**Table 1:**

| Calculated oxide thickness from XPS (d_{XPS}) and Spectroscopic Ellipsometry (d_{SE}) measurements and correlation to the potential difference between the PMP and the potential after 600 s immersion time (Δ_{OCP}). | | | |
|---|---|---|---|
| sample treatment | d_{XPS} (nm) | d_{SE} (nm) | Δ_{OCP} (mV) |
| SPM, 21 °C | 0.5 | 0.6 | 120 |
| SPM, 75 °C | - | 0.9 | 250 |
| SPM, 95 °C | 0.8 | 1.1 | 405 |

It is evident that the reaction rate of a process can be evaluated and quantitatively be expressed in terms of OCP data, allowing a characterization of the efficiency of the chemical mixtures used in a semiconductor treatment process, and for a characterization of their optimum working conditions. Furthermore, an endpoint of the reaction can be determined.

An endpoint can be defined, for example, as the time at which after a foregoing period (e.g. 30 seconds) a slow increase (Δ 3mV) of the OCP values is monitored. An endpoint can be defined as the crossover of a certain potential value. Other definitions of the endpoint of a chemical or physical reaction in terms of OCP data would be evident to those skilled in the art, taking into account the fact that a direct correlation between the chemical or physical process and the OCP measurements is set forth herein.

The above-described embodiments of the present invention are examples of suitable arrangements for carrying out the invention. While the invention has been described in terms of several detailed examples, many alternatives will be apparent to those of skill in the art in the light of the foregoing description. Thus, the spirit and scope of the present invention being limited only by the terms of the claims.

More particularly several applications are summarized hereunder.

The first is to study the kinetics of wet chemical oxidation processes on semiconductor surfaces which was very difficult and time consuming until now, and also the dissolution and etching behavior of semiconductor oxides and substrates. More device fabrication oriented applications are under investigation at the moment for optimization, control and end-point detection of wet chemical treatments in semiconductor device manufacturing. In the first step mixing ratios of chemicals, temperature, additive concentrations and other parameters can be much faster and more precisely optimized as was possible until now. As a result a response curve is obtained which is acting as a reference for the monitoring of the wet cleaning process with the OCP technique during the production process. This allows to control the status of the chemical bath (e.g. oxidizing power, etch rate) and helps in optimizing its lifetime to reduce chemical consumption and, with that, to reduce the chemical waste. Additionally the OCP response can be used as an end-point detector to optimize the process time as example by defining a certain slope of the OCP where the process should be stopped.

Contamination issues from the reference electrode system, when being implemented as a real time in-situ monitoring tool into a fabrication wet-bench are under investigation.

One possibility has been applied in several measurements within in this work, where the whole measurement system is based only on the immersion of 2 silicon electrodes. One, the reference wafer, being already in the final quasi-steady state (with a sufficient constant potential) the other in the state to be investigated or having a defined surface for studying the behavior of the solution. The applicability of this concept has been presented in Figure 5, where two times the same measurement is displayed, one time measured vs. an Ag/AgCl standard reference electrode the second time vs. a H-passivated Si wafer (re-calculated vs. Ag/AgCl). Besides providing a totally contamination free measurement set-up, the concept of using a second Si sample as reference results also in a smoother measurement signal. This approach results no longer in the measurement of absolute values in terms of potentials vs. a well defined reference but this is also not necessary. For process control purposes it is enough to calculate e.g. the slope of the initial oxidation response (in an oxidizing environment) or the time needed to reach the PMP or quasi-steady state potential (for oxide etching solutions) to define the cleaning bath and its interaction with the wafer. In general metrology tools need to suffice the need for sensitivity and repeatability and the possibility for in-situ and off-line mode measurements but there is no need for absolute values. All of this requirements are achieved by the OCP technique.

## Claims

1. The method for monitoring the physical or chemical action of a chemical solution on a surface of a semiconductor material in contact with said chemical solution comprising:
a. measuring the potential difference between a working electrode and a reference electrode, said reference electrode being in contact with said chemical solution, thereby obtaining measurement data,
b. obtaining condition data which indicate the physical and/or chemical condition of said semiconductor material over a predetermined period of time; and
c. correlating said condition data to said measurement data in order to monitor the physical or chemical action of said chemical solution on said surface.

2. The method according to claim 1, wherein the measurement data are obtained by measuring a transient rise in potential difference between said working electrode and said reference electrode.

3. The method according to claim 2, wherein the transient rise occurs immediately after the immersion of said semiconductor material in said chemical solution and foregoing a steady state behavior of said measurement data.

4. The method according to claim 2, wherein the measurement data are obtained by measuring a steady state behavior in the potential difference between said working electrode and said reference electrode.

5. The method according to claim 4, wherein the steady state occurs after that a transient rise occurs immediately after an immersion of said semiconductor material in said chemical solution.

6. The method according to any one of the preceding claims, wherein the working electrode comprises a material which is subjected to the action such as the oxidizing, etching, cleaning or dissolving agent of a chemical solution on a semiconductor material.

7. The method according to claim 6, wherein the material is a semiconductor material such as a silicon or germanium wafer or a piece thereof.

8. The method according to any one of the preceding claims, wherein the reference electrode is any element which does not or slowly get attacked or degraded by the solution in which the element is immersed.

9. The method according to claim 8, wherein the reference electrode is a standard Ag/AgCl electrode or a saturated calomel electrode or a normal hydrogen electrode.

10. The method according to claim 9, wherein the standard Ag/AgCl electrode can be an electrode with a PFA capillary salt bridge, a standard electrode containing two compartments covered with epoxy material wherein the upper compartment contains Ag/AgCl reference systems and the lower part the salt bridge with the porous platinum junction to the solution, and wherein a glass fiber forms the junction between the upper and the lower parts, or an electrode made from glass where the filling solution is exchanged after each measurement.

11. The method according to claim 8, wherein the reference electrode is an Si wafer and more particularly a Hydrogen-passivated or Oxygen-passivated Si wafer preferably encapsulated in PFA and which is attacked or degraded by the solution substantially slower than the working electrode.

12. The method according to any one of the preceding claims, wherein the condition data are related to a surface of said semiconductor material exposed to said chemical solution.

13. The method according to claim any one of the preceding claims, wherein the condition data indicate the physical and/or chemical condition of a surface of said semiconductor material exposed to said chemical solution.

14. The method according to any one of the preceding claims, wherein the condition data are obtained with conventional techniques for analyzing semiconductor surfaces such as contact angle measurements or infrared spectroscopy.

15. The method according to any one of the claims 1 to 14, additionally comprising the step of detecting a predetermined endpoint of said physical or chemical action on said semiconductor material.

16. The method according to any one of the claims 1 to 14, additionally comprising the following steps after step c:
d. determining a unit of condition data which indicates that said semiconductor material should be removed from said chemical solution;
e. determining a unit of measurement data which correspond to said unit of condition data; and
f. using said unit of measurement data from step e as an indication that said semiconductor material should be removed from said chemical solution defining an endpoint.

17. The method according to any one of the claims 1 to 14, additionally comprising the following steps after step c:
d. determining a unit of condition data which indicates that said semiconductor material should be removed from said chemical solution;
e. determining a unit of measurement data which corresponds to said unit of condition data; and
f. using said unit of measurement data from step e as an indication that said chemical solution should be refreshed or exchanged defining an endpoint.

18. The method according to any one of the claims 15 to 17, wherein the endpoint is reached during an interval when the potential difference between said semiconductor electrode and reference electrodes increases by less than 3mV, preferably less than 1mV.

19. The method according to claim 18, wherein said interval is period of 30 seconds.

20. The method according to any one of the claims 15 to 17, wherein said endpoint is reached when the potential difference between said semiconductor electrode and said reference electrode increases by less than 0.1mV/sec.

21. The method to any one of the claims 1 to 14, additionally comprising the following steps after step c:
d. determining a unit of condition data which indicate the oxidizing, cleaning, etching or dissolving action on said semiconductor material in a first of said chemical solutions;
e. determining a unit of measurement data which correspond to said unit of condition data for said first of said chemical solutions;
f. determining a unit of condition data which indicate the oxidizing, cleaning, etching or dissolving action on said semiconductor material in a second of said chemical solutions;
g. determining a unit of measurement data which correspond to said unit of condition data for said second of said chemical solutions;
h. comparing the data from step e. with that of step g. so as to optimize the oxidizing, cleaning, etching or dissolving action of said chemical solution.

22. The method according to claim 21, wherein said first of said chemical solutions differs from said second of said chemical solutions only in working conditions.

23. The method according to claim 22, wherein said working conditions are selected from the group consisting of temperature and amount of agitation.

24. The method according to claim 21, wherein said first of said chemical solutions differs from said second of said chemical solutions in concentration of its components.

25. The method according to any one of the claims 1 to 14, additionally comprising the following steps after step c:
d. determining an upper and lower acceptability limit for a unit of condition data which indicate the oxidizing, cleaning, etching or dissolving action of said chemical solution on said semiconductor material;
e. determining a unit of measurement data which correspond to said unit of condition data for said chemical solution;
f. determining if said unit of measurement data are within said upper and lower acceptability level;
g. refreshing or exchanging said chemical solution when said unit of measurement is outside of said upper and lower acceptability limit.

26. An apparatus for monitoring in-situ the oxidizing, cleaning, etching or dissolving action of a chemical solution on a semiconductor material immersed in said chemical solution, said apparatus consisting of a reference electrode and a working electrode and a voltmeter connected to said reference electrode and said working electrode.

27. An apparatus according to claim 26, wherein the working electrode comprises a material which is subjected to the action such as the oxidizing, etching, cleaning or dissolving agent for chemical solution on a semiconductor material.

28. An apparatus according to claim 27, wherein the material is a semiconductor material such as silicon or germanium wafer or a piece thereof.

29. An apparatus according to any one of the preceding claims 26 to 28, wherein the reference electrode is any element which does not or slowly get attacked or degraded by the solution in which the element is immersed.

30. An apparatus according to claim 29, wherein the reference electrode is a standard Ag/AgCl electrode or a saturated calomel electrode or a normal hydrogen electrode.

31. An apparatus according to claim 30, wherein the standard Ag/AgCl electrode can be an electrode with a PFA capillary salt bridge, a standard electrode containing two compartments covered with epoxy material wherein the upper compartment contains Ag/AgCl reference systems and the lower part the salt bridge with the porous platinum junction to the solution, and wherein a glass fiber forms the junction between the upper and the lower parts, or an electrode made from glass where the filling solution is exchanged after each measurements.

32. An apparatus according to claim 29, wherein wherein the reference electrode is an Si wafer and more particularly a Hydrogen-passivated or Oxygen-passivated Si wafer preferably encapsulated in PFA and which is attacked or degraded by the solution substantially slower than the working electrode.

33. Use of the method according to any one of claims 1 to 25 or of the apparatus according to any one of the claims 26 to 32 for real-time controlling or monitoring of a semiconductor fabrication process.

34. Use of the method according to any one of the claims 1 to 25 or of the apparatus according to any one of the claims 26 to 32 for in-situ controlling or monitoring of a semiconductor fabrication process.

35. Use of the method according to any one of the claims 1 to 25 or of the apparatus according to any one of the claims 26 to 32 in order to control or monitor quantitatively the semiconductor fabrication process.
